# FASCICULE DE BREVET EUROPEEN

(11) **EP 3 898 503 B1**
(45) Date de publication et mention de la délivrance du brevet: **08.10.2025**
(21) Numéro de dépôt: 19842391.5
(22) Date de dépôt: 12.12.2019
(51) Int. Cl.: B81C 1/00

(54) **PROCEDE DE FABRICATION D'UN DISPOSITIF COMPRENANT UNE MEMBRANE SURPLOMBANT UNE CAVITE**
VERFAHREN ZUR HERSTELLUNG EINER VORRICHTUNG MIT EINER SICH ÜBER EINEN HOHLRAUM ERSTRECKENDEN MEMBRAN
METHOD FOR MANUFACTURING A DEVICE COMPRISING A MEMBRANE EXTENDING OVER A CAVITY

(30) Priorité: 20.12.2018 FR 1873602
(43) Date de publication de la demande: 27.10.2021
(73) Titulaire: SOITEC, 38190 Bernin (FR)
(72) Inventeur: GHYSELEN, Bruno, 38170 Seyssinet (FR)
(74) Mandataire: IP Trust
(86) Numéro de dépôt international: PCT/FR2019/053039
(87) Numéro de publication internationale: WO 2020/128245

(56) Documents cités:
- EP-A1- 2 573 514
- EP-A1- 2 573 514
- EP-B1- 2 969 479
- JP-A- 2005 303 325
- US-A1- 2018 178 215

## Description

### DOMAINE DE L'INVENTION

La présente invention concerne le domaine de la microélectronique et des microsystèmes. Elle concerne en particulier un procédé de fabrication d'un dispositif comprenant une membrane surplombant une cavité utile.

### ARRIERE PLAN TECHNOLOGIQUE DE L'INVENTION

Les dispositifs MEMS (« Microelectromechanical systems ») sont largement utilisés pour la fabrication de capteurs divers, visant une multitude d'applications : on peut citer par exemple, les capteurs de pression, les microphones, les interrupteurs radiofréquence, les transducteurs électroacoustiques et ultrasonores (par exemple pMUT « Piezoelectric Micromachined Ultrasonic Transducer), etc.

Beaucoup de ces dispositifs MEMS sont basés sur une membrane flexible surplombant une cavité utile. En fonctionnement, le fléchissement de la membrane, lié à un paramètre physique (par exemple la propagation d'une onde acoustique pour un pMUT), est converti en un signal électrique (ou vice-versa, selon que le dispositif est en mode récepteur ou émetteur).

Selon le type de dispositif mis en œuvre, la géométrie de chaque cavité utile (forme, dimensions latérales, profondeur), de la membrane (épaisseur) et leur répartition planaire (distance inter-cavités) seront différentes.

Le document EP2573514 propose d'élaborer des capteurs d'accélération à partir d'un substrat SOI, en définissant par lithographie les différents éléments des capteurs, et en libérant les membranes mobiles par retrait local de l'oxyde enterré du substrat SOI. Le document JP2005303325 propose de graver en deux étapes une couche sacrificielle enterrée sous une couche d'arrêt, formant successivement une cavité temporaire et une cavité finale ; un dispositif est formé entre les deux étapes sur la couche d'arrêt.

La publication de Lu Yipeng et David A. Horsley, "Modeling, fabrication, and characterization of piezoelectric micromachined ultrasonic transducer arrays based on cavity SOI wafers." (Journal of Microelectromechanical Systems 24.4 (2015) 1142-1149) présente un exemple de fabrication d'un dispositif pMUT à partir d'un substrat SOI (« silicon on insulator ») présentant des cavités utiles enterrées. Ce procédé tire profit de cavités utiles préalablement formées dans un substrat pour limiter le nombre de niveaux de masques photo-lithographiques devant être employés.

L'approche est séduisante, mais elle fait porter une partie de l'effort de conception du dispositif acoustique au fabricant du substrat. Celui-ci doit en effet être apte à concevoir et à fabriquer un substrat comportant des cavités utiles se conformant précisément à la topologie (géométrie des cavités, espacement inter-cavités) requise pour le dispositif. Or, cette topologie forme souvent une information sensible et de valeur que le fabricant de dispositif ne souhaite généralement pas diffuser.

De plus, le fabricant de substrat doit développer des procédés de fabrication de substrats spécifiques à chaque topologie. Cet effort ne favorise pas le développement rapide et économique du dispositif.

Il serait donc souhaitable de pouvoir fournir un substrat apte à servir à la fabrication d'une vaste gamme de dispositifs basés sur une membrane surplombant une cavité utile, et qui ne nécessiterait donc pas le développement à façon, pour chaque dispositif, d'un procédé de fabrication spécifique de substrats.

### OBJET DE L'INVENTION

La présente invention vise à atteindre l'objectif précité. Elle concerne un procédé de fabrication d'un dispositif comprenant une membrane surplombant une cavité utile, simplifié du fait de l'utilisation d'un substrat générique.

### BREVE DESCRIPTION DE L'INVENTION

L'invention concerne un procédé de fabrication d'un dispositif comportant une membrane surplombant une cavité utile selon la revendication 1.

Selon d'autres caractéristiques avantageuses et non limitatives de l'invention, prises seules ou selon toutes combinaisons techniquement réalisables :
- les cloisons isolent les cavités élémentaires les unes des autres ;
- les cloisons sont réparties dans le plan principal selon un réseau de cloisons autorisant une communication entre les cavités élémentaires, chaque cavité élémentaire étant délimitée par un motif élémentaire du réseau de cloisons ;
- la première partie du substrat donneur présente une épaisseur comprise entre 0,2 micron et 2 microns ;
- l'assemblage comprend le collage par adhésion moléculaire entre, d'une part, le substrat donneur, et d'autre part, la première face du substrat support ;
- le retrait des cloisons situées à l'intérieur du contour du groupe de cavités élémentaires comprend la gravure locale de la couche superficielle pour former au moins une ouverture traversant ladite couche superficielle, et la gravure chimique desdites cloisons via ladite ouverture ;
- la au moins une ouverture est faite à l'aplomb des cloisons ;
- une ouverture est formée à l'aplomb de chaque cavité élémentaire du groupe de cavités élémentaires ;
- le retrait des cloisons situées à l'intérieur du contour du groupe de cavités élémentaires comprend la gravure locale d'une seconde face du substrat support pour former au moins une ouverture débouchant dans une des cavités du groupe de cavités élémentaires, et la gravure chimique desdites cloisons via ladite ouverture ;
- les cloisons comprennent au moins un matériau compris parmi l'oxyde de silicium, le nitrure de silicium, le silicium monocristallin, poly-cristallin, amorphe ou poreux ;
- le substrat donneur comprend au moins un matériau semi-conducteur ou piézoélectrique.

### BREVE DESCRIPTION DES FIGURES

D'autres caractéristiques et avantages de l'invention ressortiront de la description détaillée de l'invention qui va suivre en référence aux figures annexées sur lesquelles :
[Fig. 1a]
   [Fig. 1b]
   [Fig. 1c]
   [Fig. 1d]
   [Fig. 1e]

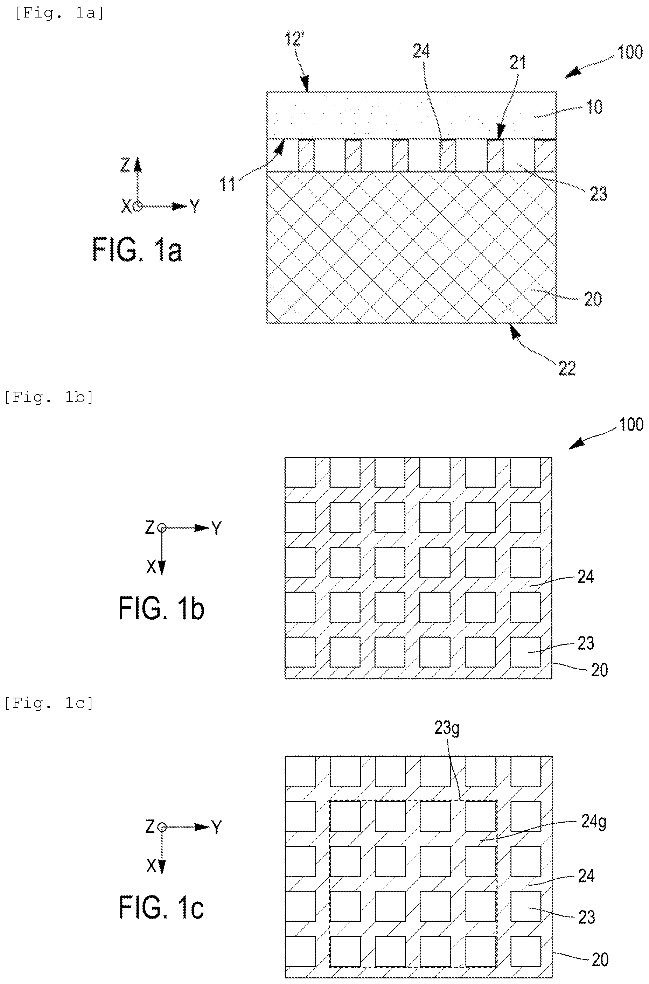

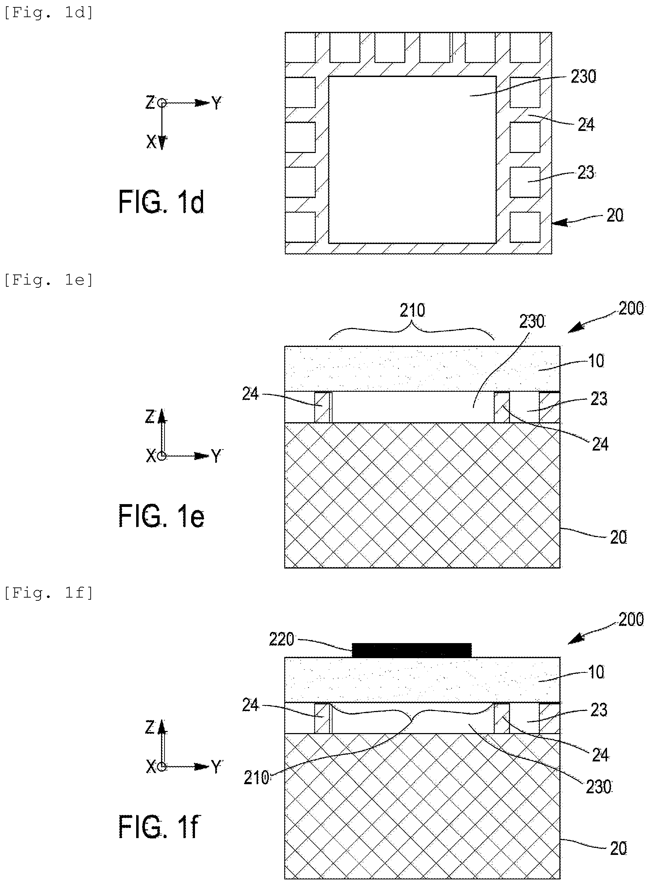

   [Fig. 1f] Les figures 1a à 1f présentent un procédé de fabrication d'un dispositif comprenant une membrane disposée sur une cavité utile, conforme à l'invention ;
[Fig. 2a]

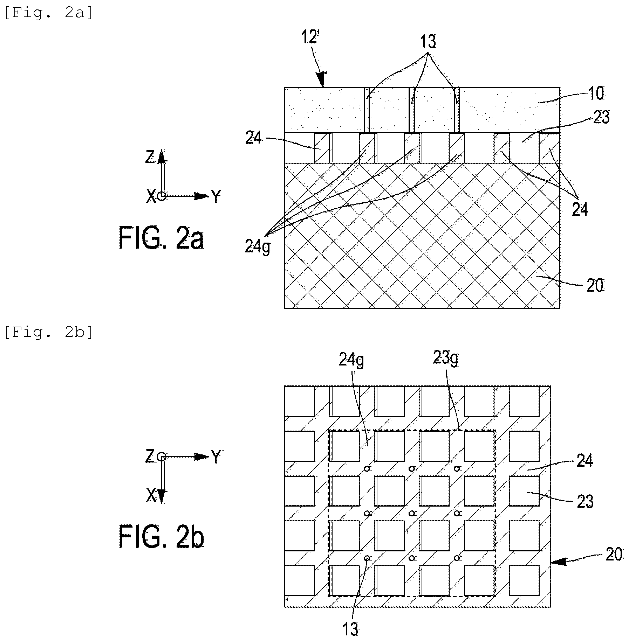

   [Fig. 2b] Les figures 2a et 2b présentent des étapes d'un procédé de fabrication conforme à l'invention ;
[Fig. 3a]
   [Fig. 3b]

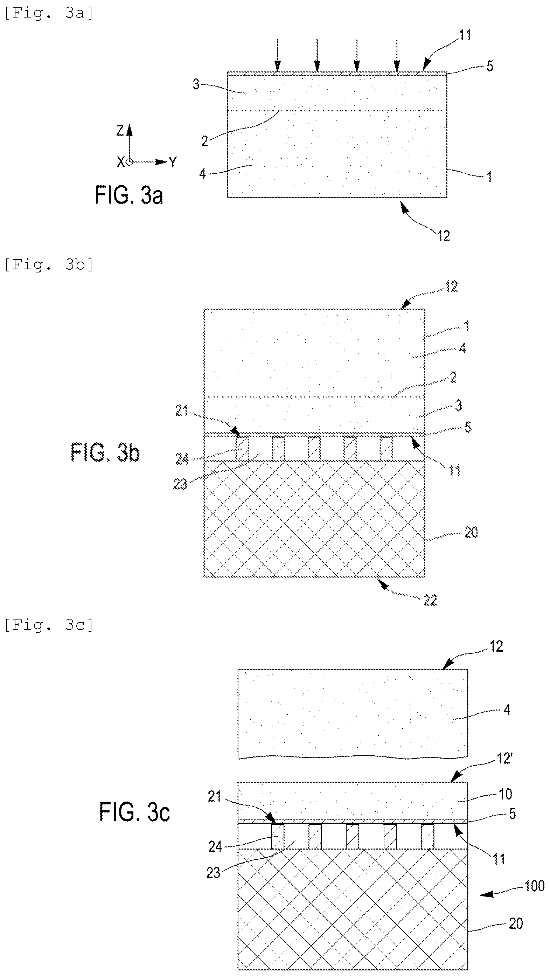

   [Fig. 3c] Les figures 3a à 3c présentent d'autres étapes d'un procédé de fabrication conforme à l'invention ;
[Fig. 4a]
   [Fig. 4b]
   [Fig. 4c]
   [Fig. 4d]
   [Fig. 4e]
   [Fig. 4f]
   [Fig. 4g]
   [Fig. 4h]
   [Fig. 4i]

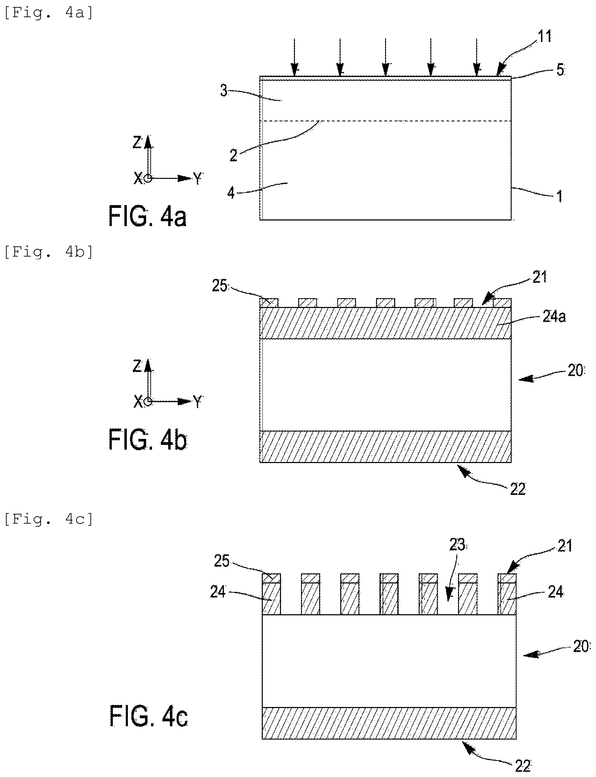

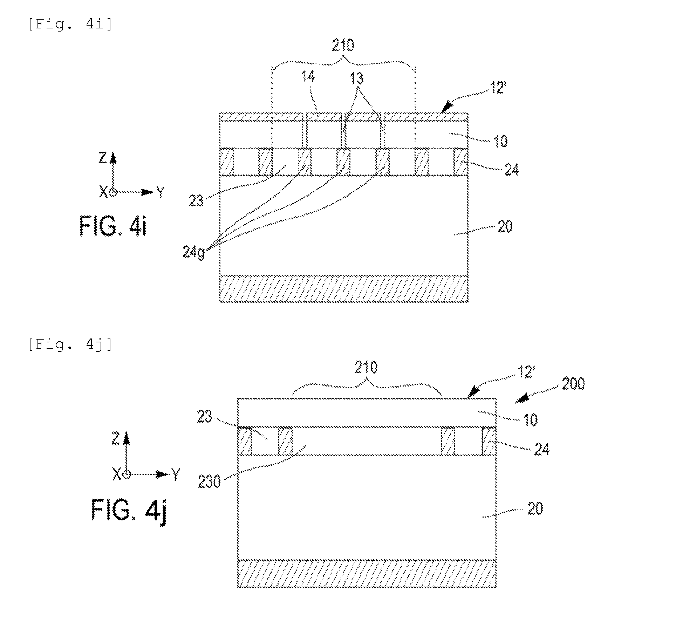

   [Fig. 4j] Les figures 4a à 4j présentent un exemple de réalisation du procédé de fabrication conforme à l'invention ;
[Fig. 5a]
   [Fig. 5b]
   [Fig. 5c]
   [Fig. 5d]

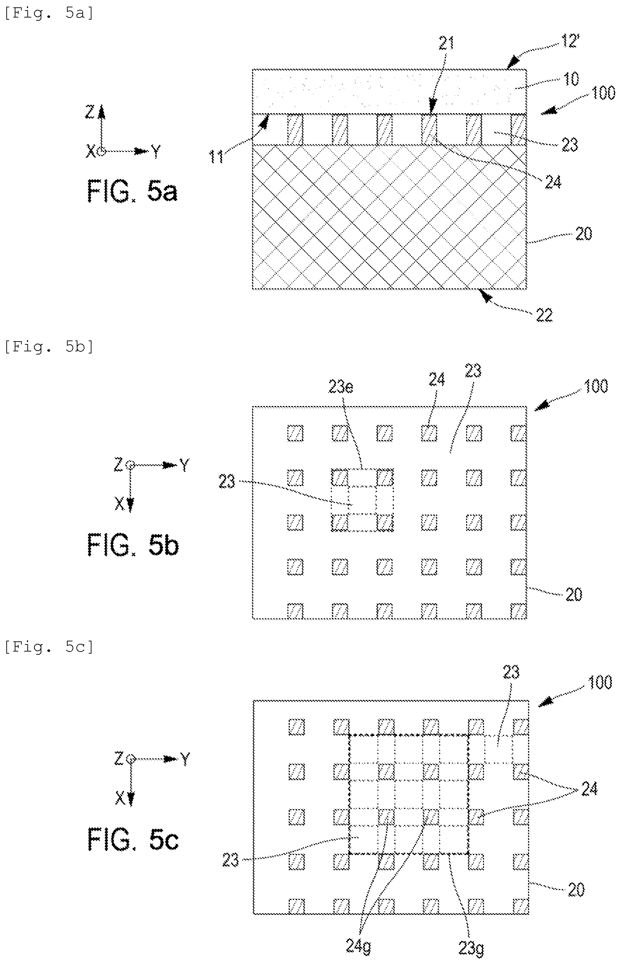

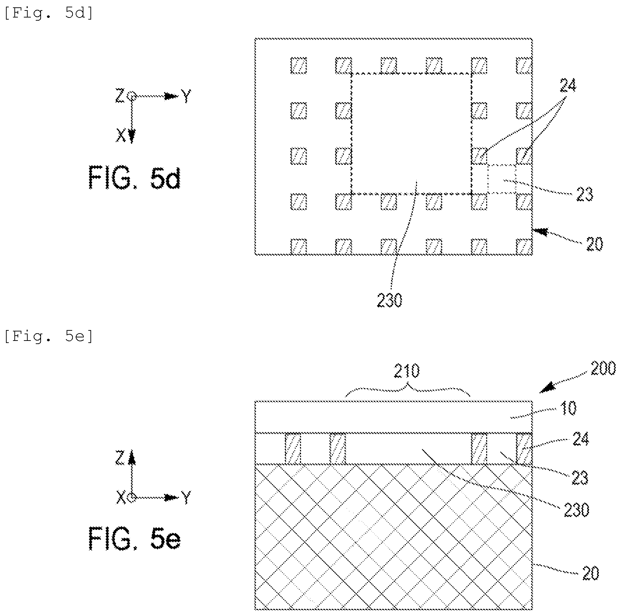

   [Fig. 5e] Les figures 5a à 5e présentent des étapes d'un procédé de fabrication conforme à l'invention.

### DESCRIPTION DETAILLEE DE L'INVENTION

Dans la partie descriptive, les mêmes références sur les figures pourront être utilisées pour des éléments de même type. Les figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y ; et les épaisseurs relatives des couches entre elles ne sont pas nécessairement respectées sur les figures.

L'invention concerne un procédé de fabrication d'un dispositif 200 comportant une membrane 210 surplombant une cavité utile 230 (figures 1e et 1f). A titre d'exemple, ledit dispositif 200 pourra consister en un transducteur ultrasonore ou acoustique.

Le procédé de fabrication selon l'invention comprend tout d'abord une étape de fourniture d'une structure générique 100 comportant une couche superficielle 10 s'étendant selon un plan principal (x,y) et disposée sur une première face 21 d'un substrat support 20. Le substrat support 20 comporte des cavités élémentaires 23 débouchant sous la couche superficielle 10 et des cloisons 24 normales au plan principal (x,y), délimitant chaque cavité élémentaire 23 (figures 1a, 5a). Les surfaces supérieures des cloisons 24 forment au moins en partie la première face 21 du substrat support 20.

A titre d'exemple, et sans que cela soit limitatif, les cloisons 24 comprennent au moins un matériau parmi l'oxyde de silicium, le nitrure de silicium, le silicium monocristallin, poly-cristallin, amorphe ou poreux.

Selon un premier mode de réalisation avantageux, les cloisons 24 isolent complètement les cavités élémentaires 23 les unes des autres. Comme illustré en vue plane sur la figure 1b, les cloisons 24 forment avantageusement des cloisons organisées en quadrillage dans le plan principal (x,y) permettant d'isoler chaque cavité élémentaire 23 de ses voisines et donc de délimiter chaque cavité élémentaire 23.

Les cavités élémentaires 23 sont ici représentées de forme carrée, alternativement, elles pourraient présenter une forme rectangulaire, circulaire ou toute autre forme géométrique.

Selon un deuxième mode de réalisation de l'invention, les cavités élémentaires 23 ne sont pas isolées les unes des autres. Les cloisons 24 sont réparties, préférentiellement de manière uniforme, dans le plan principal (x,y), selon un réseau de cloisons 24, comme l'exemple illustré sur la figure 5b. Toutes les cloisons 24 ne se rejoignent pas entre elles et forment des cloisons locales et/ou des piliers. Dans ce mode de réalisation, on appelle cavité élémentaire 23 la cavité à l'intérieur d'un motif élémentaire 23e du réseau de cloisons 24. Dans l'exemple de la figure 5b, le motif élémentaire 23e correspond à un motif carré fictivement défini par quatre cloisons 24 voisines ; la cavité élémentaire 23 est délimitée par les quatre cloisons 24 voisines et correspond à la zone intérieure de ce motif élémentaire 23e.

La surface supérieure (dans le plan principal (x,y)) d'une cloison 24 est ici représentée de forme carrée, alternativement, elle pourrait présenter une forme rectangulaire, circulaire ou toute autre forme géométrique. Les cloisons 24 pourraient également être réparties selon un réseau en quinconce ou autre répartition uniforme. A titre d'exemple, et sans que cela soit limitatif, les dimensions d'une cloison 24 dans le plan principal (x,y) pourront être de l'ordre de 5 microns, 7 microns, 10 microns ou encore 15 microns.

Le procédé de fabrication comprend ensuite une étape de définition d'un groupe 23g de cavités élémentaires 23 voisines dont le contour extérieur, dans le plan principal (x,y), correspond à un contour de la cavité utile 230 (figures 1c, 5c). On parle bien-sûr ici de la définition d'au moins un groupe 23g de cavités élémentaires : en effet, dans le cas d'une structure générique 100 formée d'un substrat support 20 de diamètre compris entre 100mm et 300mm, c'est une pluralité de groupes 23g qui sera défini, selon une répartition déterminée, dans le plan principal (x,y).

Cette étape de définition dépend du type de dispositif 200 visé, en particulier, elle dépend des dimensions latérales requises de la (ou des) cavité(s) utile(s) 230 dans le plan principal (x,y) ; ces dimensions latérales pourront varier de quelques dizaines microns à quelques centaines de microns, voire quelques millimètres. L'étape de définition dépend également de l'espacement inter-cavités utiles requis pour ledit dispositif 200 : cet espacement pourra par exemple varier de quelques dizaines de microns à quelques centaines de microns, voire quelques millimètres.

Notons que cette étape de définition et les étapes subséquentes pourront être préférentiellement réalisées par le fabricant de dispositif, le fabricant de substrat ayant uniquement en charge la fourniture de la structure générique 100. Alternativement, le fabricant de substrat pourra mettre en œuvre l'étape de définition à la demande du client et selon un cahier des charges fixé par ce dernier.

Le procédé de fabrication selon l'invention comprend ensuite une étape de retrait de cloisons 24 situées à l'intérieur du contour du groupe 23g de cavités élémentaires 23 ; lesdites cloisons seront nommées par la suite cloisons temporaires 24g.

Le retrait des cloisons temporaires 24g comprend avantageusement la gravure locale de la couche superficielle 10 pour former au moins une ouverture 13 traversant ladite couche superficielle 10, dans la zone définie du groupe 23g de cavités élémentaires (figures 2a et 2b).

Une telle gravure locale peut être réalisée par photolithographie et gravure chimique sèche ou humide. En particulier, un masque (non représenté) déposé sur la face libre 12' de la couche superficielle 10 permet de délimiter les zones à graver pour former les ouvertures 13 et de protéger le reste de la surface libre 12'. Notons que des marques d'alignement, définies sur la périphérie du substrat support 20 et/ou dans des zones prévues pour des chemins de découpe sur sa première face 21 et/ou au niveau de sa deuxième face 22, lors de la formation des cavités élémentaires 23 et des cloisons 24 sur le substrat support 20, permettent un positionnement précis vis-à-vis desdites cloisons 24 et cavités 23 enterrées lors de cette étape de retrait. Ces marques pourront également servir pour des étapes ultérieures nécessitant un alignement vis-à-vis de la (ou des) cavité(s) utile(s) 230 du dispositif 200.

Selon une première variante, illustrée sur la figure 2b, la (au moins une) ouverture 13 est faite à l'aplomb des cloisons temporaires 24g.

Selon une deuxième variante, applicable en particulier au premier mode de réalisation de l'invention, l'ouverture 13 est formée à l'aplomb d'au moins une des cavités élémentaires 23 du groupe 23g de cavités élémentaires (non représenté).

Pour les variantes précitées, il est possible de reboucher la (au moins une) ouverture 13, par exemple par dépôt de silicium poly-cristallin, sous vide ou atmosphère contrôlée.

Selon une troisième variante (non représentée), le retrait des cloisons temporaires 24g peut comprendre la formation d'au moins une ouverture 13 par gravure locale de la seconde face 22 du substrat support 20, jusqu'aux cavités du groupe 23g de cavités élémentaires 23. Avantageusement, une telle gravure au niveau de la seconde face 22 est réalisée en fin de fabrication du dispositif MEMS 200, en particulier quand le substrat support 20 est aminci par exemple à 400, 200, 100, 50 microns ou moins. Cela permet de réaliser une ouverture 13 de petite taille tout en restant dans les ratios épaisseur gravée / dimensions de l'ouverture accessibles par les techniques connues de gravure chimique. Notons que cette variante permet de laisser la membrane (partie de la couche superficielle 10 située à l'aplomb du groupe 23g de cavités élémentaires 23) intègre en évitant que l'ouverture 13 ne la traverse.

Dans l'une ou l'autre des variantes énoncées, une gravure chimique sèche ou humide apte à attaquer le matériau des cloisons 24 est ensuite effectuée, via l'ouverture 13, pour éliminer les cloisons temporaires 24g (figures 1d, 5d) et libérer la couche superficielle 10 (composant la membrane 210) sur toute l'étendue de la cavité utile 230.

A l'issue de l'étape de retrait des cloisons temporaires 24g, on obtient un dispositif 200 comportant une membrane 210 surplombant une cavité utile 230 (figure 1e).

Le procédé de fabrication selon l'invention de ce dispositif 200 est simplifié par l'utilisation d'une structure 100 dite générique, qui ne requiert pas, lors de son élaboration, de connaitre la géométrie et la répartition des cavités utiles 230. La structure générique 100 comporte une pluralité de cavités élémentaires 23 et une pluralité de cloisons 24 dont certaines 24g sont temporaires car destinées à être éliminées, pour former une (ou des) cavité(s) utile(s) 230 définie(s) à partir d'un (ou plusieurs) groupe(s) 23g de cavités élémentaires.

Dans le premier mode de réalisation de l'invention, où la structure générique 100 comprend des cavités élémentaires 23 isolées les unes des autres par les cloisons 24, la membrane 210 située au-dessus de la cavité utile 230 suite au retrait des cloisons temporaires 24g est maintenue sur tout son pourtour par des cloisons 24 (figures 1d et 1e). Dans le deuxième mode de réalisation de l'invention, où les cloisons 24 de la structure générique 100 n'isolent pas entre elles les cavités élémentaires 23, la membrane 210 située au-dessus de la cavité utile 230 suite au retrait des cloisons temporaires 24g est maintenue localement sur son pourtour par des cloisons 24 (figures 5d et 5e). L'un ou l'autre des modes de réalisation peut être envisageable selon le type de dispositif 200 visé.

La structure générique 100 présente donc l'avantage de pouvoir être utilisée pour fabriquer une multitude de dispositifs 200 basés sur des topologies variées de cavités utiles 230, susceptibles d'être formées à partir d'un groupe 23g de cavités élémentaires 23.

Par ailleurs, l'élaboration de la cavité utile 230 par retrait des cloisons temporaires 24g est avantageuse en ce qu'elle ne requiert qu'un faible enlèvement de matière, les cloisons ayant une largeur réduite, ce qui limite le temps de gravure et permet d'atteindre des dimensions précises de cavité utile 230.

Le procédé de fabrication (quel que soit le mode de réalisation) peut également comprendre des étapes complémentaires de fabrication du dispositif 200 sur la couche superficielle 10 et en particulier sur la membrane 210 et en périphérie de celle-ci. Ces étapes complémentaires pourront notamment comprendre des étapes de photolithographie, de gravure et de dépôts de couches isolantes et/ou électriquement conductrices pour définir et former par exemple des électrodes 220, au-dessus de chaque membrane 210 (figure 1f).

Notons que ces étapes complémentaires peuvent alternativement être réalisées avant l'étape de retrait des cloisons temporaires 24g, pour tirer profit de la tenue mécanique de la couche superficielle 10 par lesdites cloisons temporaires 24g sous-jacentes, sur toute l'étendue (dans le plan principal (x,y)) de la structure 100.

Selon un mode de mise en œuvre avantageux de l'invention, l'étape de fourniture de la structure générique 100 comprend en premier lieu, la fourniture d'un substrat donneur 1. Le substrat donneur 1 présente une face avant 11, destinée à être assemblée sur le substrat support 20 et une face arrière 12. A titre d'exemple, et sans que cela soit limitatif, le substrat donneur 1 pourra comprendre au moins un matériau semi-conducteur, par exemple du silicium, du carbure de silicium, etc., ou un matériau piézoélectrique, par exemple du tantalate de lithium, du niobate de lithium, du nitrure d'aluminium, d'oxyde de zinc, du PZT, etc.

Deuxièmement, l'étape de fourniture de la structure générique 100 comprend la fourniture du substrat support 20 comportant une première face 21, destinée à être assemblée sur le substrat donneur 1, et une seconde face 22. Il comporte en outre les cavités élémentaires 23 débouchant au niveau de la première face 21 et des cloisons 24 dont la surface supérieure constitue tout ou partie de la première face 21.

A titre d'exemple non limitatif, le substrat support 20 pourra comprendre du silicium, du verre, du saphir, etc.

La forme des cavités élémentaires 23 dans le plan principal (x,y) pourra être circulaire, carrée, rectangulaire ou polygonale. Les dimensions latérales des cavités élémentaires 23 dans le plan principal (x,y) sont avantageusement inférieures à 50 microns, voire inférieures à 25 microns, voire encore inférieures à 10 microns. L'espacement inter-cavités élémentaires 23, correspondant à la largeur des cloisons 24, pourra varier d'un micron à quelques dizaines de microns. A titre d'exemple, et sans que cela soit limitatif, la largeur des cloisons 24 pourra être de l'ordre de 5 microns, 7 microns, 10 microns ou encore 15 microns. La surface supérieure des cloisons 24 pourra présenter une forme circulaire, carrée, rectangulaire ou polygonale.

La profondeur des cavités élémentaires 23, selon l'axe z normal au plan principal (x,y) (correspondant également à la hauteur des cloisons 24) pourra varier de quelques dizaines de nanomètres à quelques dizaines de microns, voire quelques centaines de microns, selon le dispositif 200 visé.

Troisièmement, l'étape de fourniture de la structure générique 100 comprend l'assemblage de la face avant 11 du substrat donneur 1 et de la première face 21 du substrat support 20. L'assemblage comprend préférentiellement un collage direct par adhésion moléculaire. Le principe de l'adhésion moléculaire, bien connu dans l'état de l'art ne sera pas décrit plus en détail ici. Notons qu'un très bon état de surface (propreté, faible rugosité, ...) des substrats à assembler est requis, pour obtenir une bonne qualité d'assemblage.

Avantageusement, pour garantir une bonne qualité d'assemblage, l'étape d'assemblage comprend un nettoyage des surfaces à assembler du substrat donneur 1 et du substrat support 20, préalablement à la mise en contact desdites surfaces. A titre d'exemple, une séquence classique utilisée en microélectronique, notamment pour des substrats à base de silicium, comprend un nettoyage à l'ozone, un nettoyage de type SC1 (« Standard Clean 1 ») et un nettoyage de type SC2 (« Standard Clean 2 »), avec des rinçages intercalés. Une activation des surfaces à assembler, par exemple par plasma, pourra également être réalisée avant la mise en contact, pour favoriser une forte énergie de collage entre lesdites surfaces.

Optionnellement, le substrat donneur 1 et/ou le substrat support 20 pourront comprendre une couche de collage, respectivement au niveau de la face avant 11 et/ou au niveau de la première face 21, pour favoriser la qualité de collage et l'énergie de collage de leur interface.

Quatrièmement, l'étape de fourniture de la structure générique 100 comprend l'amincissement du substrat donneur 1 de manière à former la couche superficielle 10.

Selon une première variante de ce mode de mise en œuvre avantageux ne faisant pas parti de l'invention, l'amincissement du substrat donneur 1 est opéré par rectification mécanique (« grinding »), par polissage mécano-chimique et/ou par gravure chimique au niveau de sa face arrière 12. A l'issue de l'étape d'amincissement, on obtient la couche superficielle 10 disposée sur le substrat support 20 et présentant une face libre 12' amincie (figure 1a).

Selon cette variante, l'épaisseur de la couche superficielle 10 peut être comprise entre quelques microns et plusieurs dizaines, voire centaines de microns.

Selon une deuxième variante de ce mode de mise en œuvre avantageux, l'amincissement est réalisé à partir du procédé Smart Cut^{™}, basé sur une implantation d'ions légers et un détachement au niveau de la zone implantée.

Ainsi, selon cette deuxième variante, l'étape de fourniture du substrat donneur 1 précédemment énoncée, comprend l'implantation d'espèces légères dans ledit substrat donneur 1, de manière à former une zone fragile 2 enterrée s'étendant entre une première partie 3 du substrat donneur, destinée à former la couche superficielle 10, et une deuxième partie 4 du substrat donneur 1 destinée à former le reste du substrat donneur (figure 3a). Préférentiellement une couche intermédiaire 5 est disposée sur la face avant 11 du substrat donneur 1, préalablement à l'implantation. Cette couche intermédiaire 5 pourra être conservée, retirée et/ou remplacée par une couche de collage préalablement à l'étape d'assemblage.

L'énergie d'implantation des espèces légères (par exemple l'hydrogène ou l'hélium) conditionne l'épaisseur de la première partie 3, et donc de la future couche superficielle 10. Avantageusement, l'énergie d'implantation est choisie de manière à ce que la première partie 3 du substrat donneur 1 présente une épaisseur de l'ordre de 0,2 micron - 2 microns.

Le substrat donneur 1 est ensuite assemblé au substrat support 20 conformément à l'étape d'assemblage du procédé (figure 3b).

Toujours selon cette deuxième variante, l'étape d'amincissement du substrat donneur 1 comprend la séparation, au niveau de la zone fragile enterrée 2, entre la couche superficielle 10 (formée par la première partie 3 détachée) et le reste 4 du substrat donneur 1 (figure 3c). Cette séparation est préférentiellement réalisée au cours d'un traitement thermique à une température comprise entre quelques centaines de degrés et 700°C. Elle pourra alternativement être assistée mécaniquement ou réalisée après le traitement thermique, au moyen d'une sollicitation mécanique.

A l'issue de l'étape d'amincissement, on obtient la couche superficielle 10 transférée sur le substrat support 20 (figure 3c). Rappelons que le procédé Smart Cut^{™} permet l'obtention de couches minces présentant une excellente uniformité d'épaisseur.

Dans certains cas où l'épaisseur de la couche superficielle 10 transférée par le procédé Smart Cut^{™} est insuffisante, il est possible de ré-augmenter cette épaisseur en déposant une couche additionnelle sur la surface libre 12' de la couche superficielle 10, par exemple par croissance épitaxiale ou autres méthodes de dépôt connues, au cours d'un traitement de finition évoqué ci-après.

Selon l'une et l'autre des deux variantes d'amincissement précédemment énoncées, lorsque la couche superficielle 10 est disposée sur le substrat support 20, l'étape d'amincissement peut comprendre un traitement de finition visant à améliorer la qualité cristalline (élimination de défauts dans la couche), la qualité de surface (élimination de la rugosité résiduelle sur la surface libre 12') et/ou à modifier l'épaisseur de la couche superficielle 10. Ce traitement de finition pourra inclure un ou plusieurs traitement(s) thermique(s), polissage(s) mécano-chimique(s), gravure(s) chimique(s), croissance épitaxiale, et/ou dépôt de couches additionnelles.

### Exemple de mise en œuvre :

Dans le présent exemple, le dispositif 200 visé requiert une membrane 210 en silicium d'épaisseur 1,5 micron surplombant une cavité utile 230 de forme carrée d'environ 104 microns de côté et d'un micron de profondeur.

Le procédé de fabrication selon l'invention prévoit en premier lieu la fourniture d'une structure générique 100 comportant une couche superficielle en silicium de 1,5 micron et des cavités élémentaires 23 de forme carrée de 20 microns de côté, d'un micron de profondeur et espacées de 8 microns.

Le substrat donneur 1 est un substrat en silicium (figure 4a). Une couche d'oxyde de silicium 5, par exemple de l'ordre de 100 nm, est formée (par exemple par oxydation thermique) sur sa face avant 11 préalablement à l'implantation des espèces légères. L'énergie d'implantation est choisie à 210 keV, avec des espèces d'hydrogène à une dose de 7^{E}16/cm2. On forme ainsi une zone fragile enterrée 2, s'étendant dans le plan principal (x,y) entre une première partie 3 et une deuxième partie 4 du substrat 1 et située à une profondeur d'environ 1,9 micron.

La couche d'oxyde 5 pourra être conservée ou retirée préalablement à l'étape d'assemblage sur le substrat support 20.

Le substrat support 20 est un substrat en silicium. Une couche d'oxyde thermique 24a présentant une épaisseur de 2 microns est formée sur ledit substrat 20. Cette couche d'oxyde thermique 24a est formée sur la première face 21 et la seconde face 22 du substrat 20. La couche d'oxyde thermique présente sur la seconde face 22 pourra être conservée en tout ou partie ou retirée selon les cas. Alternativement, une couche d'oxyde pourra être déposée (par une technique connue de dépôt) uniquement sur la première face 21 du substrat support 20.

Par photolithographie, un masque 25 est ensuite défini sur la première face 21 du substrat support 20, comportant des zones non masquées au niveau desquelles la couche d'oxyde thermique 24a pourra être gravée et des zones masquées au niveau desquelles ladite couche 24a sera protégée (figure 4b). Notons que des marques d'alignement sont également définies sur la périphérie du substrat support 20 et/ou dans des zones de chemins de découpe, pour les étapes ultérieures de photolithographie qui viseront à retrouver les coordonnées des cavités élémentaires 23, lorsqu'elles seront enterrées sous la couche superficielle 10.

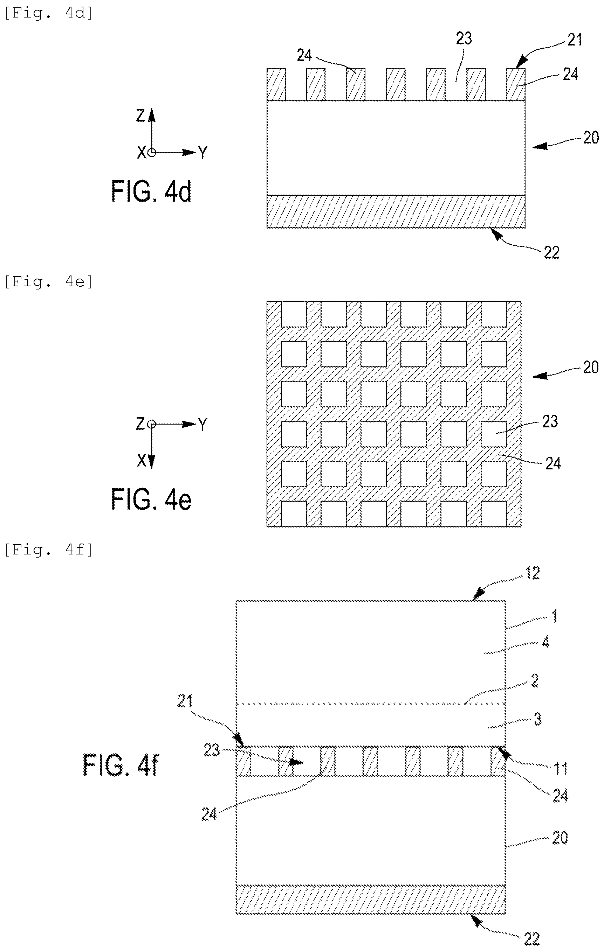

Les zones non masquées sont définies selon la taille et la répartition planaire visée des cavités élémentaires 23 de la structure générique 100. Au niveau de ces zones non masquées, on opère la gravure chimique sèche ou humide, de la couche d'oxyde thermique 24a, sur toute son épaisseur, soit 2 microns (figure 4c). Le masque 25 est ensuite retiré (figure 4d).

Typiquement, dans cet exemple, chaque cavité élémentaire 23 mesure 20 microns de côté, et des cloisons 24 réparties en quadrillage, de 8 microns de largeur, isolent les cavités élémentaires 23 les unes des autres (figure 4e).

Après une séquence de nettoyage et d'activation, la face avant 11 du substrat donneur 1 et la première face 21 du substrat support 20 sont mises en contact et collées par adhésion moléculaire (figure 4f). Notons que le collage direct pourra être réalisé sous atmosphère ambiante ou atmosphère contrôlée (pression et nature du gaz). Un recuit de consolidation de l'interface de collage peut être appliqué à la structure collée à une température de l'ordre de 350°C.

La séparation au niveau de la zone fragile enterrée 2 s'effectue au cours d'un traitement thermique de détachement, à une température de l'ordre de 500°C.

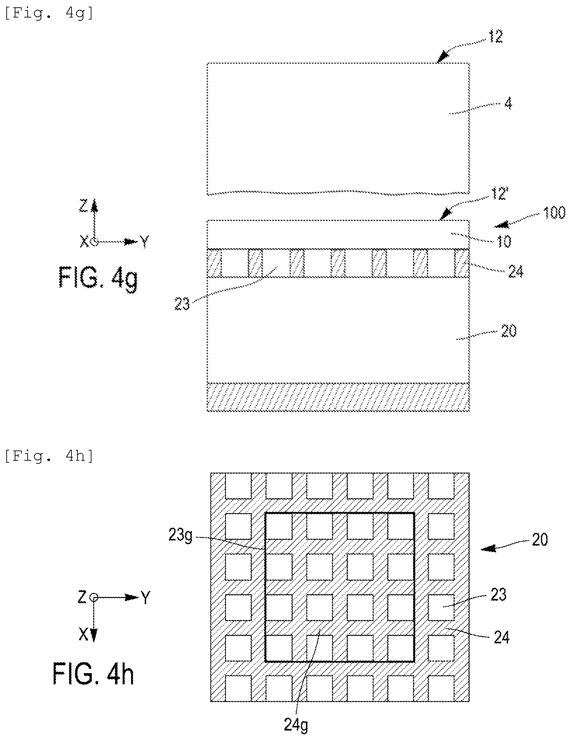

On obtient alors la structure générique 100, comprenant la couche superficielle 10 disposée sur la pluralité de cavités élémentaires 23 du substrat support 20 (figure 4g).

Des traitements de finition, tels qu'un traitement thermique oxydant et un polissage mécano-chimique sont préférentiellement opérés pour garantir une bonne qualité structurelle et de surface à la couche superficielle 10 transférée et pour aboutir à une épaisseur de 1,5 micron.

L'étape de définition d'au moins un groupe 23g de cavités élémentaires 23 voisines dont le contour extérieur, dans le plan principal, correspond à un contour de la cavité utile 230 est ensuite opéré. Comme illustré sur la figure 4h, pour former une cavité utile 230 d'environ 104 microns de côté, on définit un groupe 23g de seize cavités élémentaires 23. Les cloisons séparant ces seize cavités élémentaires 23 sont les cloisons temporaires 24g destinées à être éliminées lors de la prochaine étape du procédé de fabrication.

Pour l'étape de retrait des cloisons 24 temporaires, un masque 14, par exemple en nitrure de silicium, est défini par photolithographie, à partir des marques d'alignement prévues sur le substrat support 20, pour délimiter des zones non masquées au niveau desquelles seront formées les ouvertures 13 traversant la couche superficielle 10, le reste de la face libre 12 de la couche superficielle 10 étant masqué et donc protégé. Une gravure locale sèche ou humide de la couche superficielle 10 en silicium est opérée pour former les ouvertures 13, la section de chaque ouverture 13 étant choisie ici inférieure à la surface supérieure des cloisons 24g (figure 4i) et étant positionnée à des croisements du quadrillage formant les cloisons temporaires 24g.

En présence des ouvertures 13, une gravure chimique, par exemple sèche, à base de vapeurs d'acide fluorhydrique (HF) est effectuée pour éliminer l'oxyde thermique constituant les cloisons temporaires 24g, et ainsi libérer la couche superficielle 10 sur toute l'étendue de la cavité utile 230 pour former la membrane 210.

Le masque 14 peut être retiré, avant la gravure chimique des cloisons temporaires 24g ou à l'issue de l'étape de retrait desdites cloisons 24g.

Notons qu'en fonction du procédé choisi pour l'étape de retrait des cloisons temporaires 24g, une sur-gravure pourra s'opérer au niveau des cloisons 24 définissant la cavité utile 230, et donc modifier sensiblement les dimensions de ladite cavité utile 230 et de la membrane 210 associée. Il faudra donc tenir compte de ces potentiels effets de sur-gravure et/ou adapter le procédé choisi pour l'étape de retrait des cloisons temporaires 24g, pour l'obtention d'une cavité utile 230 aux bonnes dimensions.

Les ouvertures 13 peuvent ensuite être rebouchées si nécessaire.

On obtient ainsi le dispositif 200 visé, comportant une membrane 210 surplombant une cavité utile 230, l'épaisseur de la couche superficielle 10 (membrane 210) ainsi que la géométrie de la cavité utile 230 sont conformes au cahier des charges énoncé précédemment.

## Revendications

1. Procédé de fabrication d'un dispositif (200) comportant une membrane (210) surplombant une cavité utile (230), le procédé comprenant les étapes suivantes :
- La fourniture d'une structure générique (100) comportant une couche superficielle (10) s'étendant selon un plan principal (x,y) et disposée sur une première face (21) d'un substrat support (20), ledit substrat support (20) comportant des cavités élémentaires (23) débouchant sous la couche superficielle (10) et des cloisons (24) délimitant chaque cavité élémentaire (23), lesdites cloisons (24) présentant des surfaces supérieures qui forment tout ou partie de la première face (21) du substrat support (20) ; l'étape de fourniture d'une structure générique (100) comprenant :
* La fourniture d'un substrat donneur (1), comprenant l'implantation d'espèces légères dans ledit substrat donneur (1), de manière à former une zone fragile enterrée (2) s'étendant entre une première partie (3) du substrat donneur (1), destinée à former la couche superficielle (10), et une deuxième partie (4) du substrat donneur (1) destinée à former le reste du substrat donneur (1),
* La fourniture du substrat support (20) comportant les cavités élémentaires (23) débouchantes, et les cloisons (24) qui délimitent chaque cavité élémentaire (23) et dont les surfaces supérieures forment tout ou partie de la première face (21) du substrat support (20),
* L'assemblage du substrat donneur (1) et du substrat support (20) au niveau de la première face (21) du substrat support (20),
* L'amincissement du substrat donneur (1), comprenant la séparation, au niveau de la zone fragile enterrée (2), entre la couche superficielle (10) et le reste (4) du substrat donneur (1), de manière à former la couche superficielle (10) disposée sur la pluralité de cavités élémentaires (23) du substrat support (20);
- La définition d'un groupe (23g) de cavités élémentaires (23) voisines, de sorte qu'un contour dudit groupe (23g) de cavités élémentaires (23) corresponde, dans le plan principal (x,y), à un contour de la cavité utile (230) ;
- Le retrait des cloisons (24g) situées à l'intérieur du contour du groupe (23g) de cavités élémentaires (23), pour former la cavité utile (230), et pour libérer la couche superficielle (10) disposée au-dessus de ladite cavité utile (230) et composant la membrane (210).

2. Procédé de fabrication selon la revendication précédente, dans lequel les cloisons (24) isolent les cavités élémentaires (23) les unes des autres.

3. Procédé de fabrication selon la revendication 1, dans lequel les cloisons (24) sont réparties dans le plan principal (x,y) selon un réseau de cloisons autorisant une communication entre les cavités élémentaires (23), chaque cavité élémentaire (23) étant délimitée par un motif élémentaire (23e) du réseau de cloisons.

4. Procédé de fabrication selon l'une des revendications précédentes, dans lequel la première partie (3) du substrat donneur (1) présente une épaisseur comprise entre 0,2 micron et 2 microns.

5. Procédé de fabrication selon l'une des revendications précédentes, dans lequel l'assemblage comprend le collage par adhésion moléculaire entre, d'une part, le substrat donneur (1), et d'autre part, la première face (21) du substrat support (20).

6. Procédé de fabrication selon l'une des revendications précédentes, dans lequel le retrait des cloisons (24g) situées à l'intérieur du contour du groupe (23g) de cavités élémentaires (23) comprend la gravure locale de la couche superficielle (10) pour former au moins une ouverture (13) traversant ladite couche superficielle (10), et la gravure chimique desdites cloisons (24g) via ladite ouverture (13).

7. Procédé de fabrication selon la revendication précédente, dans lequel la au moins une ouverture (13) est faite à l'aplomb des cloisons (24g).

8. Procédé de fabrication selon la revendication 6, dans lequel une ouverture (13) est formée à l'aplomb de chaque cavité élémentaire (23) du groupe (23g) de cavités élémentaires.

9. Procédé de fabrication selon l'une des revendications 1 à 5, dans lequel le retrait des cloisons (24g) situées à l'intérieur du contour du groupe (23g) de cavités élémentaires (23) comprend la gravure locale d'une seconde face (22) du substrat support (20) pour former au moins une ouverture (13) débouchant dans une des cavités (23) du groupe (23g) de cavités élémentaires (23), et la gravure chimique desdites cloisons (24g) via ladite ouverture (13).

10. Procédé de fabrication selon l'une des revendications précédentes, dans lequel les cloisons (24) comprennent au moins un matériau compris parmi l'oxyde de silicium, le nitrure de silicium, le silicium monocristallin, poly-cristallin, amorphe ou poreux.

11. Procédé de fabrication selon l'une des revendications 1 à 10, dans lequel le substrat donneur (1) comprend au moins un matériau semi-conducteur ou piézoélectrique.

## Patentansprüche

1. Herstellungsverfahren für eine Vorrichtung (200), die eine Membran (210) beinhaltet, die einen nutzbaren Hohlraum (230) überspannt, wobei das Verfahren die folgenden Schritte umfasst:
- Bereitstellung einer generischen Struktur (100), die eine Oberflächenschicht (10) beinhaltet, die sich entlang einer Hauptebene (x, y) erstreckt und auf einer ersten Seite (21) eines Trägersubstrats (20) angeordnet ist, wobei das Trägersubstrat (20) elementare Hohlräume (23) beinhaltet, die unter der Oberflächenschicht (10) münden, und Trennwände (24), die jeden elementaren Hohlraum (23) begrenzen, wobei die Trennwände (24) obere Flächen aufweisen, die die erste Seite (21) des Trägersubstrats ganz oder teilweise bilden (20) bilden;
den Schritt des Bereitstellens einer generischen Struktur (100), umfassend:
* Bereitstellung eines Donorsubstrats (1), umfassend das Einbringen von leichten Spezies in das Donorsubstrat (1), so dass ein verdeckter fragiler Bereich (2) gebildet wird, der sich zwischen einem ersten Teil (3) des Donorsubstrats (1), der zur Bildung der Oberflächenschicht (10) bestimmt ist, und einem zweiten Teil (4) des Donorsubstrats (1), der zur Bildung des restlichen Donorsubstrats (1) bestimmt ist, erstreckt,
* Bereitstellung des Trägersubstrats (20), das die durchgängigen elementaren Hohlräume (23) und die Trennwände (24) beinhaltet, die jeden elementaren Hohlraum (23) begrenzen und deren oberen Flächen die gesamte oder einen Teil der ersten Seite (21) des Trägersubstrats (20) bilden,
* Verbinden des Donorsubstrats (1) und des Trägersubstrats (20) an der ersten Seite (21) des Trägersubstrats (20),
* Verdünnen des Donorsubstrats (1), umfassend das Trennen der Oberflächenschicht (10) und des Rests (4) des Donorsubstrats (1) an dem verdeckten fragilen Bereich (2), um die Oberflächenschicht (10) zu bilden, die auf der Vielzahl von elementaren Hohlräumen (23) des Trägersubstrats (20) angeordnet ist;
- Definition einer Gruppe (23g) benachbarter elementarer Hohlräume (23), sodass eine Kontur der Gruppe (23g) elementarer Hohlräume (23) in der Hauptebene (x, y) einer Kontur des nutzbaren Hohlraums (230) entspricht;
- Entfernen der Trennwände (24g), die sich innerhalb der Kontur der Gruppe (23g) von elementaren Hohlräumen (23) befinden, um den nutzbaren Hohlraum (230) zu bilden und die Oberflächenschicht (10) freizulegen, die über dem nutzbaren Hohlraum (230) angeordnet ist und die Membran (210) ausmacht.

2. Herstellungsverfahren nach dem vorstehenden Anspruch, wobei die Trennwände (24) die elementaren Hohlräume (23) voneinander isolieren.

3. Herstellungsverfahren nach Anspruch 1, wobei die Trennwände (24) in der Hauptebene (x, y) gemäß einem Netz von Trennwänden verteilt sind, das eine Verbindung zwischen den elementaren Hohlräumen (23) ermöglicht, wobei jeder elementare Hohlraum (23) durch ein elementares Muster (23e) des Netzes von Trennwänden begrenzt ist.

4. Herstellungsverfahren nach einem der vorstehenden Ansprüche, wobei der erste Teil (3) des Donorsubstrats (1) eine Dicke im Bereich zwischen 0,2 Mikrometer und 2 Mikrometer aufweist.

5. Herstellungsverfahren nach einem der vorstehenden Ansprüche, wobei die Verbindung eine Verklebung durch molekulare Haftung zwischen dem Donorsubstrat (1) auf der einen Seite und der ersten Seite (21) des Trägersubstrats (20) auf der anderen Seite umfasst.

6. Herstellungsverfahren nach einem der vorstehenden Ansprüche, wobei das Entfernen der Trennwände (24g), die sich innerhalb der Kontur der Gruppe (23g) von elementaren Hohlräumen (23) befinden, das lokale Ätzen der Oberflächenschicht (10), um mindestens eine Öffnung (13) zu bilden, die die Oberflächenschicht (10) durchquert, und das chemische Ätzen der Trennwände (24g) über die Öffnung (13) umfasst.

7. Herstellungsverfahren nach einem der vorstehenden Ansprüche, wobei die mindestens eine Öffnung (13) senkrecht zu den Trennwänden (24g) ausgefertigt ist.

8. Herstellungsverfahren nach Anspruch 6, wobei eine Öffnung (13) senkrecht zu jedem elementaren Hohlraum (23) der Gruppe (23g) von elementaren Hohlräumen gebildet ist.

9. Herstellungsverfahren nach einem der Ansprüche 1 bis 5, wobei das Entfernen der Trennwände (24g), die sich innerhalb der Kontur der Gruppe (23g) von elementaren Hohlräumen (23) befinden, das lokale Ätzen einer zweiten Seite (22) des Trägersubstrats (20), um mindestens eine Öffnung (13) zu bilden, die in einen der Hohlräume (23) der Gruppe (23g) von elementaren Hohlräumen (23) mündet, und das chemische Ätzen der Trennwände (24g) über die Öffnung (13) umfasst.

10. Herstellungsverfahren nach einem der vorstehenden Ansprüche, wobei die Trennwände (24) mindestens ein Material umfassen, das aus Siliziumoxid, Siliziumnitrid, monokristallinem, polykristallinem, amorphem oder porösem Silizium ausgewählt ist.

11. Herstellungsverfahren nach einem der Ansprüche 1 bis 10, wobei das Donorsubstrat (1) mindestens ein halbleitendes oder piezoelektrisches Material umfasst.

## Claims

1. A method for manufacturing a device (200) containing a membrane (210) extending over a useful cavity (230), the method comprising the following steps:
- providing a generic structure (100) containing a surface layer (10) extending in a main plane (x, y) and arranged on a first face (21) of a carrier substrate (20), said carrier substrate (20) containing elementary cavities (23) opening under the surface layer (10) and partitions (24) delimiting each elementary cavity (23), said partitions (24) having upper surfaces which form all or part of the first face (21) of the carrier substrate (20);
the step of providing a generic structure (100) comprising:
* providing a donor substrate (1), comprising implanting light species in the donor substrate (1), so as to form a buried fragile area (2) which lies between a first portion (3) of the donor substrate (1), intended to form the surface layer (10), and a second portion (4) of the donor substrate (1) intended to form the rest of the donor substrate (1),
* providing the carrier substrate (20) containing the open-through elementary cavities (23), and the partitions (24) which delimit each elementary cavity (23) and whose upper surfaces form all or part of the first face (21) of the carrier substrate (20),
* assembling the donor substrate (1) and the carrier substrate (20) at the first face (21) of the carrier substrate (20),
* thinning the donor substrate (1), comprising separating, at the level of the buried fragile area (2), between the surface layer (10) and the rest (4) of the donor substrate (1), so as to form the surface layer (10) arranged on the plurality of elementary cavities (23) of the carrier substrate (20);
- defining a group (23g) of neighbouring elementary cavities (23), so that a contour of said group (23g) of elementary cavities (23) corresponds, in the main plane (x, y), to a contour of the useful cavity (230);
- removing the partitions (24g) located within the contour of the group (23g) of elementary cavities (23), to form the useful cavity (230), and to clear the surface layer (10) arranged above the useful cavity (230) and making up the membrane (210).

2. Manufacturing method according to the preceding claim, wherein the partitions (24) isolate the elementary cavities (23) from each other.

3. The manufacturing method according to claim 1, wherein the partitions (24) are distributed in the main plane (x,y) according to an array of partitions enabling a communication between the elementary cavities (23), each elementary cavity (23) being delimited by an elementary pattern (23e) of the array of partitions.

4. The manufacturing method according to one of the preceding claims, wherein the first portion (3) of the donor substrate (1) has a thickness comprised between 0.2 micron and 2 microns.

5. The manufacturing method according to one of the preceding claims, wherein the assembly comprises bonding the donor substrate (1), on the one hand, and the first face (21) of the carrier substrate (20), on the other hand, by molecular adhesion.

6. The manufacturing method according to one of the preceding claims, wherein the removal of the partitions (24g) located within the contour of the group (23g) of elementary cavities (23) comprises local etching of the surface layer (10) to form at least one aperture (13) throughout said surface layer (10), and chemical etching of said partitions (24g) via said aperture (13).

7. The manufacturing method according to the preceding claim, wherein the at least one aperture (13) is formed directly over the partitions (24g).

8. The manufacturing method according to claim 6, wherein an aperture (13) is formed directly over each elementary cavity (23) of the group (23g) of elementary cavities.

9. The manufacturing method according to one of claims 1 to 5, wherein the removal of the partitions (24g) located within the contour of the group (23g) of elementary cavities (23) comprises local etching of a second face (22) of the carrier substrate (20) to form at least one aperture (13) opening into one of the cavities (23) of the group (23g) of elementary cavities (23), and chemical etching of said partitions (24g) via said aperture (13).

10. The manufacturing method according to one of the preceding claims, wherein the partitions (24) comprise at least one material selected from among silicon oxide, silicon nitride, monocrystalline, polycrystalline, amorphous or porous silicon.

11. The manufacturing method according to one of claims 1 to 10, wherein the donor substrate (1) comprises at least one semiconductor or piezoelectric material.
